# FASCICULE DE BREVET EUROPEEN

(11) **EP 1 012 644 B1**
(45) Date de publication et mention de la délivrance du brevet: **14.05.2003**
(21) Numéro de dépôt: 98943973.2
(22) Date de dépôt: 11.09.1998
(51) Int. Cl.: G02B 6/28, H01S 5/40

(54) **DISPOSITIF D'AMPLIFICATION ET DE COUPLAGE OPTIQUE DU TYPE A INTERFERENCE MULTIMODE ET PROCEDES UTILISANT UN TEL DISPOSITIF**
ANORDNUNG ZUR OPTISCHEN VERSTÄRKUNG UND KOPPLUNG NACH DEM MULTIMODEN-INTERFERENZ-PRINZIP UND DEREN ANWENDUNGEN
OPTICAL AMPLIFYING AND COUPLING APPARATUS OF THE MULTIMODE INTERFERENCE TYPE AND METHODS OF USING SUCH APPARATUS

(30) Priorité: 12.09.1997 FR 9711391
(43) Date de publication de la demande: 28.06.2000
(73) Titulaire: ALCATEL, 75382 Paris Cédex 08 (FR)
(72) Inventeur: DEVAUX, Fabrice, F-92120 Montrouge (FR); VERGNOL, Eric, F-92160 Antony (FR)
(74) Mandataire: Lamoureux, Bernard
(86) Numéro de dépôt international: FR9801954
(87) Numéro de publication internationale: WO99014623

(56) Documents cités:
- WO-A-95/02264
- WO-A-96/08044
- US-A- 4 087 159
- JENKINS R M ET AL: "1-N-WAY PHASED ARRAY RESONATOR" CONFERENCE ON LASERS AND ELECTRO-OPTICS, vol. 8, 1 janvier 1994, page 228 XP000444286
- HAMAMOTO K ET AL: "Single transverse mode active multimode interferometer InGaAsP/InP laser diode" ELECTRONICS LETTERS, 5 MARCH 1998, IEE, UK, vol. 34, no. 5, pages 462-464, XP002086489 ISSN 0013-5194
- Proceedings European Conference on Integrated Optics ECIO'97 2-4avril 1997, Stockolm, PD5-1 à 4

## Description

La présente invention concerne un coupleur à interférences multimodes (ou coupleur interférométrique multimode : coupleur MMI), pouvant par exemple être utilisé dans un amplificateur semi-conducteur pour les télécommunications.

Le coupleur selon l'invention peut trouver application dans la réalisation de composants optiques sur semi-conducteur InP ou AsGa (laser, laser-modulateur, ...).

Un exemple d'application est la réalisation d'un amplificateur délivrant une puissance optique plus importante qu'un amplificateur semi-conducteur standard.

Un autre exemple d'application concerne tous les systèmes de transmission où un amplificateur très linéaire est nécessaire.

Les coupleurs du type à interférence multimode, ainsi que leur application à l'optique intégrée, sont déjà connus dans l'art antérieur : des exemples de coupleurs et leurs applications sont donnés dans les articles de L.B. SOLDANO, Journal of Lightwave Technology, vol.13, n°4, page 615, 1995 et dans l'article de P.A. BESSE, Journal of Lightwave Technology, vol.14, n°10, page 2290, 1996.

Dans le domaine des amplificateurs semi-conducteurs, on connaît des amplificateurs semi-conducteurs standards, et des amplificateurs semi-conducteurs à surface élargie.

Le composant type d'un amplificateur semi-conducteur standard est un guide d'onde monomode sur semi-conducteur, dont le coeur contient un matériau de type laser. Quand un courant est injecté, le matériau présente un gain et l'onde lumineuse est amplifiée.

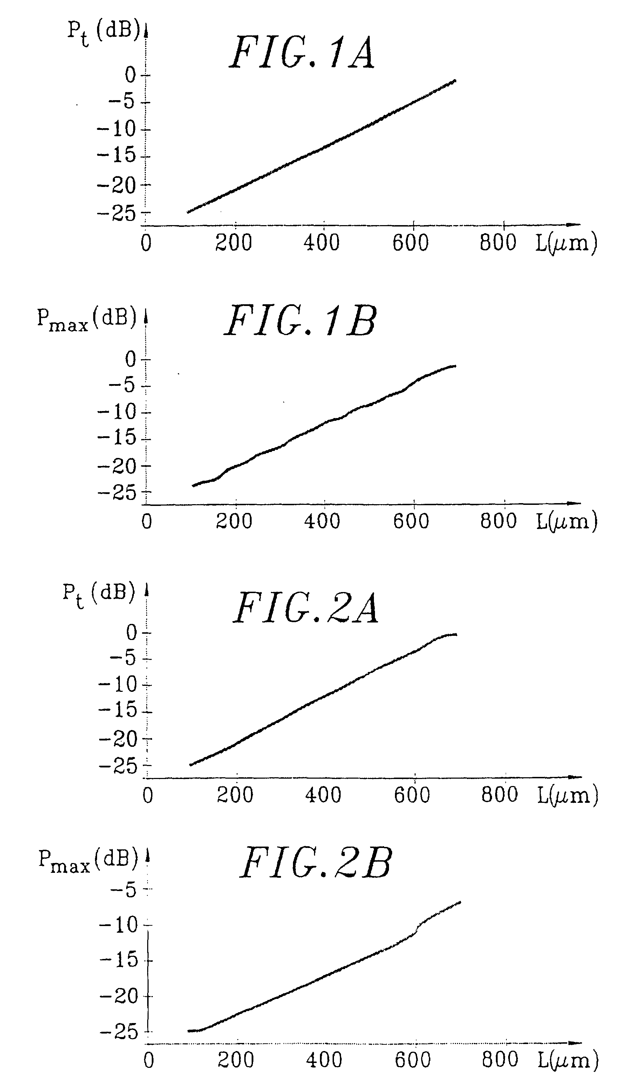

Les figures 1A et 1B représentent l'évolution, respectivement de la puissance totale et de la puissance maximale dans une même section d'un tel amplificateur semi-conducteur standard. Dans l'exemple donné, on injecte une puissance lumineuse de -25 dBm et la puissance totale en sortie est de 0 dBm. La puissance maximum suit la même progression.

Les amplificateurs à surface élargie permettent d'augmenter la puissance de sortie du dispositif en faisant en sorte que la densité maximum de puissance n'atteigne pas le niveau de puissance de saturation. Cette dernière est uniquement fixée par le matériau et le courant. Pour cela, le guide d'onde est progressivement élargi. Bien que le guide d'onde devienne multimode, l'onde lumineuse reste couplée dans le mode principal et s'élargit progressivement.

Il en résulte que le gain reste le même (25 dB) mais que la puissance de saturation augmente d'environ 7 dB. Les figures 2A et 2B représentent l'évolution, respectivement de la puissance totale et de la puissance maximale dans une même section d'un amplificateur semi-conducteur à surface élargie.

Ce type de dispositif présente deux désavantages :
(i) il est difficile de coupler la lumière de sortie dans un guide d'onde monomode ou dans une fibre optique,
(ii) la structure est potentiellement instable vis-à-vis d'une modification locale de puissance induisant une modification d'indice, qui induit un couplage de l'onde dans un mode supérieur, et de nouveau une modification locale de puissance, etc.

Enfin, on connaît, par la communication de K. HAMAMOTO parue dans EICO'97, 2-4 Avril 1997, Stockholm, un MMI où tout le matériau actif du coupleur est un amplificateur.

### EXPOSÉ DE L'INVENTION

La présente invention concerne on dispositif d'amplification et de coupage du type à interférence multimode, tel que defini à la revendication 1.

Par rapport à ces dispositifs connus, le dispositif à interférence multimode selon l'invention présente deux parties, une partie amplificatrice et une partie en un matériau transparent, permettant de guider le rayonnement amplifié dans la première partie.

La structure selon l'invention permet de réaliser un amplificateur possédant environ le même gain et la même puissance de saturation qu'un amplificateur à surface élargie. Il permet également un couplage de toute la lumière amplifiée dans un guide monomode, avec un minimum de pertes. Enfin, le coupleur à interférence multimode selon l'invention ne présente pas l'instabilité caractéristique d'un amplificateur à surface élargie conventionnel car, de par sa nature multimode, l'invention est peu sensible à une fluctuation d'indice.

Par rapport au dispositif décrit dans l'article de K. Hamamoto cité ci-dessus, une partie seulement du coupleur multimode est utilisée en amplificateur. En effet dans la première partie du MMI selon l'invention, la puissance optique est déconcentrée et il est donc avantageux d'y amplifier le rayonnement. Dans la deuxième partie du MMI selon l'invention, la puissance optique est concentrée, par exemple sur un guide de sortie, et il est important de ne pas l'amplifier, pour ne pas saturer l'amplificateur. Le dispositif de Hamamoto ne tire donc pas profit d'une amplification sélective dans les zones où la puissance optique est faible, au contraire du dispositif objet de la présente invention.

De plus, le dispositif décrit par Hamamoto ne fait pas usage d'une partie en matériau transparent, mais est uniquement un dispositif d'amplification.

Un guide monomode peut être placé en sortie du coupleur selon l'invention.

Par ailleurs, le matériau amplificateur peut être une structure enterrée dans un substrat InP.

Le matériau amplificateur peut être un matériau laser, par exemple un alliage quaternaire InGaAsP. Ce matériau peut aussi être à puits quantiques.

Le dispositif de l'invention Peut également comporter un préamplificateur optique en amont du tronçon de guide d'ondes multimode.

L'invention a également pour objet divers procédés :
- pour amplifier la puissance d'une source de lumière,
- ou pour compenser les pertes d'une fibre optique
- ou pour amplifier des signaux multiplexés en longueur d'onde,
ces divers procédés mettant en oeuvre un dispositif d'amplification et de couplage optique selon l'invention.

### BRÈVE DESCRIPTION DES DESSINS

De toute façon, les caractéristiques et avantages de l'invention apparaissent mieux à la lumière de la description qui va suivre. Cette description porte sur les exemples de réalisation, donnés à titre explicatif et non limitatif, en se référant à des dessins annexés sur lesquels :
- les figures lA et 1B représentent l'évolution de la puissance totale et de la puissance maximale dans une même section d'un amplificateur semi-conducteur standard,
- les figures 2A et 2B représentent l'évolution de la puissance totale et de la puissance maximale dans une même section d'un amplificateur semi-conducteur à surface élargie selon l'état de la technique,
- la figure 3 représente la structure d'un dispositif selon l'invention,
- les figures 4A et 4B représentent l'évolution, respectivement de la puissance totale et de la puissance maximale dans une même section d'un dispositif selon l'invention,
- la figure 5 représente schématiquement un dispositif selon l'invention, de type 1x1,
- les figures 6A à 6D représentent diverses formes de frontière entre les deux parties d'un dispositif selon l'invention,
- la figure 7 est un exemple d'utilisation d'un dispositif selon l'invention, dans un dispositif intégré.

### EXPOSÉ DÉTAILLÉ DE MODES DE RÉALISATION DE L'INVENTION

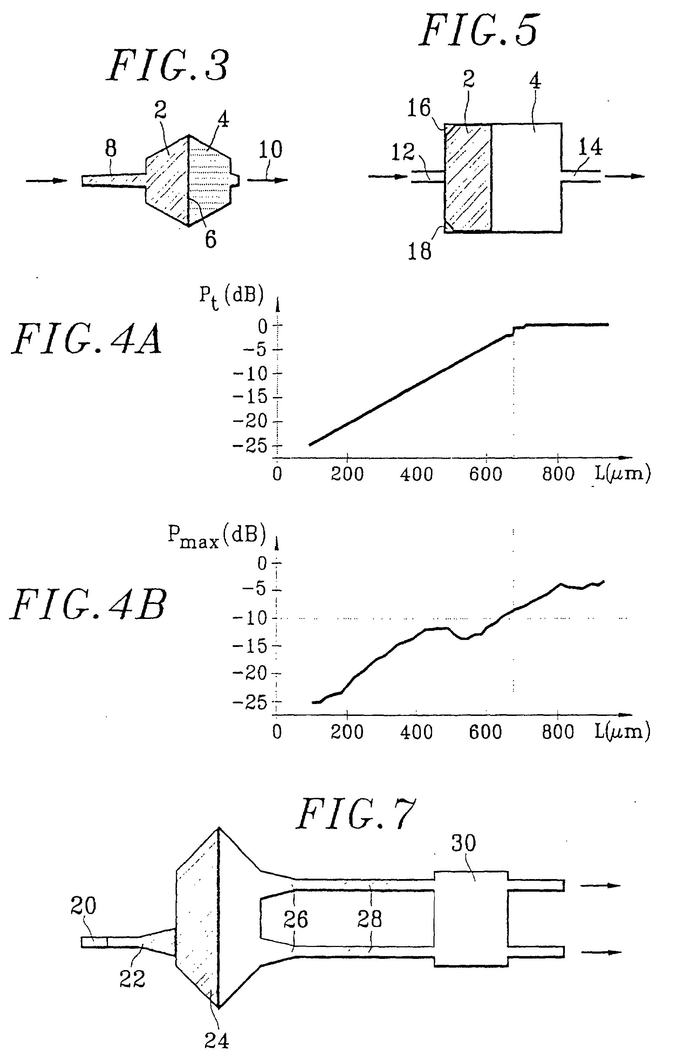

La figure 3 représente schématiquement la structure d'u un dispositif d'amplification et de couplage optique selon l'invention. Une premiere partie 2 est constituée d'un matériau amplificateur, et est suivie d'une partie 4 en matériau transparent passif. En fait, la première parties 2 constitue une zone amplificatrice (elle est typiquement constituée d'un matériau laser) et la deuxième partie 4 est une zone de guidage multimode, constitué d'un matériau guide ou d'un matériau laser polarisé à la transparence.

La zone amplificatrice 2 et la zone de guidage 4 sont disposées de manière essentiellement perpendiculaire ou quasi-perpendiculaire, à la direction de propagation de la lumière incidente 8 et de la lumière 10 sortant du coupleur, de manière à ne pas perturber les propriétés de ce dernier.

Le dispositif qui vient d'être décrit se distingue d'autres dispositifs en onde guidée, tels que des « tapers » ou des lentilles, du fait qu'il est constitué d'une structure en ondes guidées multimode. L'onde lumineuse incidente est, effectivement, couplée sur la plupart des modes du coupleur.

La forme du coupleur est choisie de manière à ce que le champ lumineux en entrée soit reproduit en sortie, en un ou plusieurs endroits, avec une atténuation, et un déphasage variable. Les conditions permettant d'obtenir ce résultat sont données dans l'article de L.B. SOLDANO, déjà cité ci-dessus dans l'introduction de la présente demande.

Les figures 4A et 4B représentent respectivement la puissance totale et la puissance maximale dans une section longitudinale d'un coupleur selon l'invention, au cours de la propagation. Sur ces deux figures, le trait vertical indique la fin de la zone amplificatrice, ou la zone de frontière 6, entre la zone amplificatrice et le matériau guide. D'après ces figures, on voit que le gain reste de 25 dB mais que la puissance maximale est de -10 dBm, au lieu de 0 dBm pour une structure standard. La puissance de saturation est donc plus élevée de 10 dB. De plus, la lumière peut bien être recouplée dans un guide d'onde monomode. Le coupleur selon l'invention ne présente pas l'instabilité caractéristique de l'amplificateur à surface élargie connu car, de part sa nature multimode, le coupleur selon l'invention est peu sensible à une fluctuation d'indice.

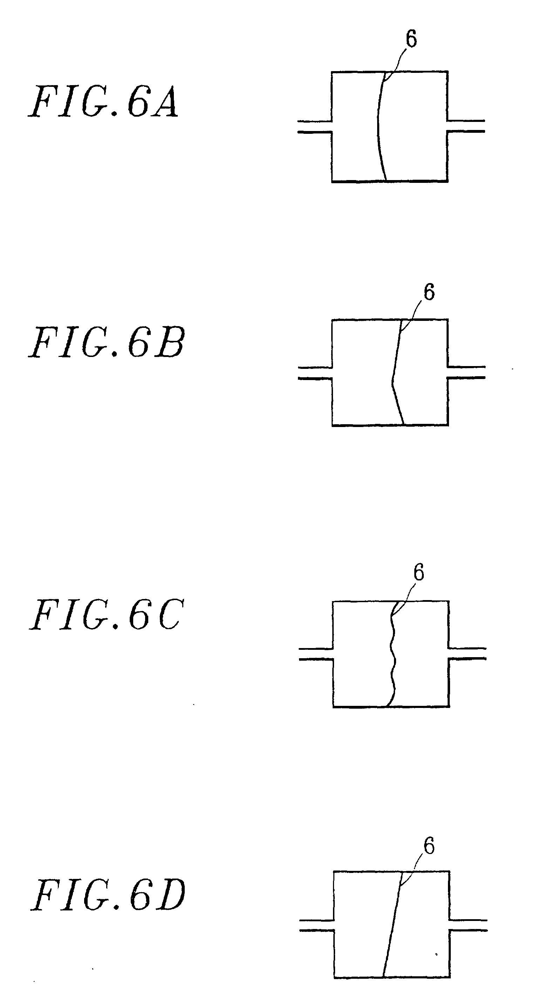

La figure 5 représente un exemple de coupleur 1x1, c'est-à-dire avec un guide d'entrée 12 et un guide de sortie 14. Conformément à l'invention, une partie 2 du coupleur est utilisée en amplificateur. L'interface entre le milieu amplificateur et la zone guidée 4 peut être verticale ; mais elle peut être aussi légèrement inclinée (avec, par exemple, un angle de 2 à 8°) par rapport à cette verticale, et ceci afin d'éviter les problèmes de réflexion. Les deux premiers coins 16, 18 de coupleur ne sont pas nécessairement en matériau amplificateur car la lumière ne parvient pas dans ces régions.

D'autres exemples de structures de coupleurs selon l'invention, et en particulier d'interface entre les zones d'amplification et de guidage, sont données sur les figures 6A à 6D. Sur la figure 6A, la zone d'interface 6 est légèrement courbée. Sur la figure 6B, elle est en forme de « V ». Sur la figure 6C, elle est en « zigzag ». Enfin, la figure 6D est un exemple de coupleur avec une interface inclinée par rapport au trajet des faisceaux incidents et émis, ou par rapport à la verticale (avec un angle, par exemple, d'environ 2 à 10° avec la verticale).

Le matériau amplificateur d'un coupleur selon l'invention peut être par exemple constitué d'une structure enterrée dans InP, d'un laser en quaternaire InGaAsP, ou de puits quantiques, avec le système d'électrodes et de dopage typique d'un amplificateur, comme décrit dans l'article de L.B. SOLDANO et al déjà cité ci-dessus. La zone transparente peut être constituée du même matériau polarisé à un courant différent, ou d'un matériau InGaAsP, ou de puits quantiques d'énergie de bandes interdites supérieures.

Les techniques de fabrication d'un coupleur selon l'invention mettent en oeuvre les techniques connues de l'art antérieur. Ces techniques sont par exemple décrites dans l'ouvrage de Y. SUEMATSU et al, intitulé « Handbook of semiconductor lasers and photonic integrated circuits », chapitre 13, pages 428-458 Chapman et Hall, 1994. Une structure selon l'invention est donc réalisé selon les méthodes standards de fabrication de guides d'onde : ruban enterré, ruban en arête, ruban chargé, ... La technologie des amplificateurs est, elle, standard (structure pin enterrée ou en arête). Les techniques d'intégration utilisées peuvent être le « butt-coupling », l'épitaxie sélective, ou le couplage évanescent.

La figure 7 est un exemple d'utilisation de l'invention dans un dispositif intégré, par exemple sur semi-conducteur InP. Dans ce dispositif, de type Mach-Zehnder, le premier des coupleurs (par exemple : à 3 dB), est remplacé par un coupleur selon l'invention.

Le dispositif décrit sur la figure 7 comporte successivement, de gauche à droite, un guide d'entrée 20, un amplificateur d'entrée 22 (réalisant une étape de pré-amplification), un coupleur 24 selon l'invention (ici : un coupleur en losange 1x2, à taux de répartition inégal, avec une moitié amplifiée), deux guides de sortie 26, deux amplificateurs standards 28, et un coupleur 2x2 standard 30.

Un autre exemple d'application de l'invention est la réalisation d'un amplificateur délivrant une puissance optique plus importante qu'un amplificateur semi-conducteur standard. Le dispositif selon l'invention peut alors être utilisé en tant que composant discret, ou bien il peut être intégré avec d'autres fonctionnalités sur un substrat semi-conducteur. Par exemple, le dispositif selon l'invention peut être placé à la sortie d'un laser-modulateur pour augmenter le niveau de puissance optique.

Dans cette application, la puissance incidente est déjà relativement élevée, par rapport à la fonction de pré-amplification pour laquelle la puissance incidente est faible. L'objectif de ce type d'application est donc de pouvoir délivrer une puissance optique importante. Ce type de dispositif peut être utilisé dans les télécommunications optiques, par exemple après une source de lumière pour en augmenter le niveau de puissance. Il peut également être utilisé en ligne pour compenser les pertes d'une fibre optique. Dans les deux cas, l'avantage de l'invention par rapport à un amplificateur à fibre dopée à l'erbium (traditionnellement utilisé) est que l'amplificateur selon l'invention peut être intégré monolithiquement avec la source, pour former un composant compact.

Un autre exemple d'application concerne les systèmes de transmission où un amplificateur très linéaire est nécessaire. Par exemple, l'amplification de signaux multiplexés en longueur d'onde nécessite un amplificateur très linéaire pour éviter la diaphonie entre canaux. Or, les amplificateurs à semi-conducteurs sont rapidement non-linéaires : au-delà d'un certain niveau de puissance optique, leur gain diminue. Dans ce cas, la transmission du dispositif dépend du niveau de puissance incidente, ce qui est la définition de la non-linéarité. Or, cela peut poser divers problèmes de déformation des signaux optiques. Par exemple, si un signal incident est composé d'ondes lumineuses à plusieurs longueurs d'onde, son passage à travers un dispositif non-linéaire provoque une diaphonie entre les différents canaux. Un amplificateur plus linéaire permet de réduire l'ampleur de ce problème. Un exemple typique est celui une source intégrée monolithiquement, multilongueurs d'onde. Le dispositif selon l'invention peut servir d'amplificateur intégré pour augmenter le niveau de puissance de sortie.

Un autre exemple est un dispositif de filtrage en ligne intégré, où le signal est traité (par filtrage et modulation) avec des pertes optiques. Dans ce cas, rajouter un amplificateur selon l'invention permet d'augmenter le niveau de puissance sans distorsion.

Un autre exemple est l'utilisation de l'amplificateur pour générer le signal optique par retournement spectral du champ optique. Pour cela, on utilise les propriétés de mélange à quatre ondes des amplificateurs semi-conducteurs (voir par exemple l'article de T. Ducellier et al. intitulé "Study of optical phase conjugation in bulk travelling wave semiconductor optical amplifier", paru dans IEEE Photonics Technology Letters, vol. 8(4), p. 530 (1996)).Un amplificateur très linéaire conforme à la présente invention se comporte mieux, dans cette opération, qu'un amplificateur semi-conducteur classique et peut donc le remplacer avantageusement. L'efficacité du mélange à quatre ondes est en effet d'autant plus efficace que la puissance de sortie est élevée, ce que permet d'atteindre l'amplificateur selon l'invention.

Selon encore un autre exemple, les convertisseurs de longueur d'onde sont des dispositifs intégrés comportant divers éléments optiques, tels que guides d'onde, jonctions Y, coupleurs, amplificateurs semi-conducteurs. Pour les utiliser, il faut de très fortes puissances optiques, ce qui est peut pratique. L'invention peut donc être utilisée avantageusement comme amplificateur intégré, en utilisant les mêmes matériaux que les amplificateurs déjà présents sur la puce (ceux-ci sont d'ailleurs utilisés dans ce dispositif pour leurs propriétés non-linéaires). De par la géométrie différente, la même couche amplificatrice sert d'amplificateur non-linéaire ou linéaire, ce qui facilite la réalisation.

## Revendications

1. Dispositif d'amplification et de couplage optique du type à interférence multimode, ledit dispositif comprenant un tronçon de guide d'ondes multimode présentant deux extrémités opposées le long d'une direction générale de propagation prédéterminée, dont l'une comprend au moins une entrée destinée à recevoir de la lumière incidente, la forme dudit tronçon de guide multimode étant choisie de façon que le champ lumineux en entrée se reproduise sur l'extrémité opposée en un ou plusieurs endroits, des sorties correspondantes étant ménagées auxdits endroits de façon à en extraire la lumière, ledit tronçon de guide multimode contenant en outre un matériau amplificateur pour amplifier ladite lumière s'y propageant avant d'en être extraite par la(les)dite(s) sortie(s), ledit dispositif étant **caractérisé en ce que** ledit tronçon de guide multimode ne contient de matériau amplificateur que sur une première partie de sa longueur s'étendant à partir de l'extrémité d'entrée dudit tronçon, de façon à amplifier le rayonnement dans cette première partie longitudinale où il est spatialement déconcentré, une seconde partie longitudinale dudit tronçon de guide multimode, qui s'étend à la suite de ladite première partie longitudinale étant faite en un matériau simplement transparent, de façon à simplement reconcentrer spatialement ledit rayonnement sans en poursuivre l'amplification afin d'éviter tout risque de saturation lors de la reconcentration.

2. Dispositif selon la revendication 1, **caractérisé en ce que** la seconde partie s'étend jusqu'à l'extrémité de sortie dudit tronçon de façon à reconcentrer ledit rayonnement sur la(les)dite(s) sortie(s).

3. Dispositif d'amplification et de couplage selon la revendication 1 ou 2, **caractérise en ce que** les première et seconde parties sont séparées par une interface (6) incurvée.

4. Dispositif d'amplification et de couplage selon la revendication 1 ou 2, **caractérise en ce que** les première et deuxième parties sont séparées par une interface (6) en « V ».

5. Dispositif d'amplification et de couplage selon la revendication 1 ou 2, **caractérise en ce que** les première et deuxième parties sont séparées par une interface (6) en zigzag.

6. Dispositif d'amplification et de couplage selon la revendication 1 ou 2, **caractérise en ce que** les première et deuxième parties sont séparées par une interface (6) inclinée sur le trajet de rayons entrant (8) et sortant (10).

7. Dispositif d'amplification et de couplage selon l'une des revendications précédentes **caractérise en ce que** un guide monomode est placé sur la(es) dite(s) soctie(s) dudit tronçon de guide multimode.

8. Dispositif d'amplification et de couplage selon l'une des revendications précédentes, **caractérise en ce que** le matériau amplificateur est une structure enterrée dans un substrat en InP.

9. Dispositif d'amplification et de couplage selon l'une des revendications précédentes, caractérisé en ceque le matériau amplificateur est un matériau laser.

10. Dispositif d'amplification et de couplage selon la revendication 9, caractérisé en ceque le matériau laser est en quaternaire InGaAsP.

11. Dispositif d'amplification et de couplage selon l'une des revendications 1 à 8, caractérisé en ceque le matériau amplificateur est à puits quantiques.

12. Dispositif d'amplification et de couplage optique du type à interférence multimode selon l'une quelconque des revendications 1 à 11, **caractérisé en ce qu'**il comprend un préamplificateur optique en amont du tronçon de guide d'ondes multimode.

13. Procédé pour amplifier la puissance d'une source de lumière émettant un rayonnement, consistant à placer, sur le trajet dudit rayonnement un dispositif d'amplification et de couplage selon l'une des revendications 1 à 12.

14. Procédé pour compenser les pertes d'une fibre optique consistant à placer, sur le trajet d'un rayonnement circulant dans la fibre optique, un dispositif d'amplification et de couplage selon l'une des revendications 1 à 12.

15. Procédé d'amplification de signaux multiplexés en longueur d'onde, consistant à augmenter le niveau de puissance de sortie à l'aide d'un dispositif d'amplification et de couplage selon l'une des revendications 1 à 12.

## Claims

1. An optical amplifying and coupling device of the multi-mode interference type, said device comprising a multi-mode waveguide segment presenting two opposite ends along a general predetermined direction of propagation, one end of which has at least an inlet designed to receive the incident light, the shape of said multi-mode waveguide segment being selected in such a manner that the inlet light field is reproduced at the opposite end, at one or more locations, corresponding outlets being provided at said locations so as to extract the light thererrom, said multi-mode waveguide segment further containing an amplifying material for amplifying said light propagating therein before being extracted therefrom by said outlet(s), said device being **characterized in that** said multi-mode waveguide segment contains amplifying material only over a first portion of its length extending from the inlet end of said segment so as to amplify the radiation in said first longitudinal portion in which it is spatially deconcentrated, a second longitudinal portion of said multi-mode waveguide segment which extends after said first longitudinal portion being made of a material that is merely transparent in order merely to reconcentate said radiation spatially without having to amplify it, thereby avoiding any risk of saturation during reconcentration.

2. A device according to claim 1, **characterized in that** the second portion extends as far as the outlet end of said segment so as to reconcentrate said radiation on said outlet(s).

3. An amplifying and coupling device according to claim 1 or claim 2, **characterized in that** the first and second portions are separated by a curved interface (6).

4. An amplifying and coupling device according to claim 1 or claim 2, **characterized in that** the first and second portions are separated by a 'V" shaped interface (6).

5. An amplifying and coupling device according to claim 1 or claim 2, **characterized in that** the first and second portions are separated by a zigzag shaped interface (6).

6. An amplifying and coupling device according to claim 1 or claim 2, **characterized in that** the first and second portions are separated by an inclined interface (6) on the path of the incoming and outgoing rays (8, 10).

7. An amplifying and coupling device according to any preceding claim, **characterized in that** a single-mode waveguide is placed at said outlet(s) from said multi-mode waveguide segment.

8. An amplifying and coupling device according to any preceding claim, **characterized in that** the amplifying material is a structure embedded in an InP substrate.

9. An amplifying and coupling device according to any preceding claim, **characterized in that**, the amplifying material is a laser material.

10. An amplifying and coupling device according to claim 9, **characterized in that** the laser material is made of quatemary InGaAsP.

11. An amplifying and coupling device according to any one of claims 1 to 8, **characterized in that** the amplifying material has quantum wells.

12. An optical amplifying and coupling device of the multi-mode interference type according to any one of claims 1 to 11, **characterized in that** it comprises an optical preamplifier upstream from the multi-mode waveguide segment.

13. A method of amplifying the power of a light source emitting radiation, said method consisting in placing an amplifying and coupling device according to any one of claims 1 to 12 on the path of said radiation.

14. A method of compensating for the losses of an optical fiber, said method consisting in placing an amplifying and coupling device according to any one of claims 1 to 12 on the path of the radiation travelling along the optical fiber.

15. A method of amplifying wavelength multiplexed signals, said method consisting in increasing the output power level by means of an amplifying and coupling device according to any one of claims 1 to 12.

## Patentansprüche

1. Vorrichtung zur optischen Verstärkung und Kopplung nach dem Multimoden-Interferenz-Prinzip, mit einem Multimoden-Wellenleiterabschnitt, der entlang einer vorgegebenen allgemeinen Ausbreitungsrichtung zwei Enden aufweist, von denen das eine wenigstens einen zum Empfangen des eintreffenden Lichtes vorgesehenen Eingang umfaßt, wobei die Form des Multimoden-Leiterabschnitts so gewählt ist, dass das Eingangslichtfeld am gegenüberliegenden Ende an einem oder mehreren Orten reproduziert wird, wobei entsprechende Ausgänge an diesen Orten zum Extrahieren des Lichtes geschaffen sind, wobei der Multimoden-Leiterabschnitt ferner ein Verstärkermaterial zum Verstärken des sich darin ausbreitenden Lichtes vor dessen Extraktion über den Ausgang/die Ausgänge enthält, **dadurch gekennzeichnet, dass** der Multimoden-Leiterabschnitt Verstärkermaterial nur auf einem ersten Bereich seiner Länge enthält, der sich vom Eingangsende des Abschnittes aus erstreckt, um die Strahlung in diesem ersten Längsbereich zu verstärken, wo sie räumlich dekonzentriert ist, wobei ein zweiter Längsbereich des Multimoden-Leiterabschnittes, der sich im Anschluß an den ersten Längsbereich erstreckt, aus einem einfach transparenten Material gemacht ist, um die Strahlung einfach räumlich zu rekonzentrieren, ohne die Verstärkung fortzusetzen, um jede Gefahr einer Sättigung beim Rekonzentrieren zu vermeiden.

2. Vorrichtung nach Anspruch 1, **dadurch gekennzeichnet, dass** der zweite Bereich sich bis zum Ausgangsende des Abschnittes erstreckt, um die Strahlung auf den Ausgang/die Ausgänge zu rekonzentrieren.

3. Vorrichtung zur Verstärkung und Kopplung nach Anspruch 1 oder 2, **dadurch gekennzeichnet, dass** erster und zweiter Bereich durch eine gekrümmte Schnittstelle (6) getrennt sind.

4. Vorrichtung zur Verstärkung und Kopplung nach Anspruch 1 oder 2, **dadurch gekennzeichnet, dass** erster und zweiter Bereich durch eine V-förmige Schnittstelle (6) getrennt sind.

5. Vorrichtung zur Verstärkung und Kopplung nach Anspruch 1 oder 2, **dadurch gekennzeichnet, dass** erster und zweiter Bereich durch eine zickzackförmige Schnittstelle (6) getrennt sind.

6. Vorrichtung zur Verstärkung und Kopplung nach Anspruch 1 oder 2, **dadurch gekennzeichnet, dass** erster und zweiter Bereich durch eine in Bezug auf den Weg eintretender (8) und austretender Strahlen (10) geneigte Schnittstelle (6) getrennt sind.

7. Vorrichtung zur Verstärkung und Kopplung nach einem der vorhergehenden Ansprüche, **dadurch gekennzeichnet, dass** ein Einmodenleiter an dem Ausgang/den Ausgängen des Mulcimoden-Leiterabschnittes angebracht ist.

8. Vorrichtung zur Verstärkung und Kopplung nach einem der vorhergehenden Ansprüche, **dadurch gekennzeichnet, dass** das Verstärkermaterial eine in einem InP-Substrat vergrabene Struktur ist.

9. Vorrichtung zur Verstärkung und Kopplung nach einem der vorhergehenden Ansprüche, **dadurch gekennzeichnet, dass** das Verstärkermäterial ein Lasermaterial ist.

10. Vorrichtung zur Verstärkung und Kopplung nach Anspruch 9, **dadurch gekennzeichnet, dass** das Lasermaterial quaternäres InGaAsP ist.

11. Vorrichtung zur Verstärkung und Kopplung nach einem der Ansprüche 1 bis 8, **dadurch gekennzeichnet, dass** das Verstärkermaterial Quantentröge aufweist.

12. Vorrichtung zur Verstärkung und Kopplung nach dem Multimoden-Interferenz-Prinzip nach einem beliebigen der Ansprüche 1 bis 11, **dadurch gekennzeichnet, dass** sie einen optischen Vorverstärker vor dem Multimoden-Wellenleicerabschnitt umfaßt.

13. Verfahren zum Verstärken der Leistung einer eine Strahlung aussendenden Lichtquelle, das darin beruht, auf dem Weg der Strahlung eine Vorrichtung zur Verstärkung und Kopplung nach einem der Ansprüche 1 bis 12 zu platzieren.

14. Verfahren zum Kompensieren der Verluste einer optischen Faser, das darin beruht, auf dem Weg einer sich in der optischen Faser ausbreitenden Strahlung eine Vorrichtung zur Verstärkung und Kopplung nach einem der Ansprüche 1 bis 12 zu plazieren.

15. Verfahren zum Verstärken von wellenlängengemultiplexten Signalen, das darin beruht, den Ausgangsleistungspegel mit Hilfe einer Vorrichtung zur Verstärkung und Kopplung nach einem der Ansprüche 1 bis 12 zu erhöhen.
